(19) Europäisches Patentamt
European Patent Office
Office européen des brevets

(11) **EP 2 963 432 A1**

(12) **EUROPEAN PATENT APPLICATION**
published in accordance with Art. 153(4) EPC

(43) Date of publication:
**06.01.2016 Bulletin 2016/01**

(21) Application number: **13876674.6**

(22) Date of filing: **28.02.2013**

(51) Int Cl.:
***G01R 31/36*** *(2006.01)*

(86) International application number:
**PCT/JP2013/055481**

(87) International publication number:
**WO 2014/132403 (04.09.2014 Gazette 2014/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Hitachi Automotive Systems, Ltd.**
**Hitachinaka-shi, Ibaraki 312-8503 (JP)**

(72) Inventors:
• **IGARASHI, Naoyuki**
**Ibaraki 312-8505 (JP)**
• **OHKAWA, Keiichiro**
**Ibaraki 312-8505 (JP)**

(74) Representative: **Beetz & Partner mbB**
**Patentanwälte**
**Steinsdorfstraße 10**
**80538 München (DE)**

(54) **DEVICE FOR ASSESSING EXTENT OF DEGRADATION IN SECONDARY CELL**

(57)    A device for assessing an extent of degradation of a secondary battery, includes: a determination unit that determines whether or not a value of current flowing in the secondary battery is less than a predetermined value; a first voltage measurement unit that takes a time point at which it is determined by the determination unit that the value of the current is less than the predetermined value as being a start time point of a specific interval, and that measures a first battery voltage of the secondary battery at the start time point; a first charge amount calculation unit that obtains a first charge amount corresponding to the secondary battery based upon the measured first battery voltage; a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point; a second charge amount calculation unit that obtains a second charge amount corresponding to the secondary battery based upon the measured second battery voltage; an integrated current amount calculation unit that obtains an integrated amount of the current flowing in the secondary battery during the specific interval; and a charge capacity calculation unit that obtains a difference between the first charge amount and the second charge amount, and that calculates a charge capacity by dividing the integrated amount of the current by the difference.

FIG.3

START

S1  MEASURE CURRENT

S2  CURRENT VALUE < i0 ?  N

S3  MEASURE OCV1

S4  CALCULATE SOCV1

S5  MEASURE CURRENT

S6  INTEGRATE CURRENT

S7  CURRENT VALUE < i0 ?  N

S8  MEASURE OCV2

S9  CALCULATE SOCV2

S10  CALCULATE ΔSOC

S11  CALCULATE CHARGE CAPACITY Q

S12  CALCULATE EXTENT OF DEGRADATION SOH

S13  DETERMINE DETERIORATION

END

## Description

TECHNICAL FIELD

The present invention relates to a device for assessing the extent of degradation of a secondary battery, that assesses the extent of degradation of a secondary battery.

BACKGROUND ART

Generally a secondary battery that can be charged and discharged, such as is represented by a lithium ion battery or a nickel-hydrogen battery, deteriorates due to repeatedly being charged and discharged, and, as compared with its initial charge capacity, its charge capacity progressively decreases.

With a device that employs a secondary battery, it is necessary to ascertain the present charge capacity of the secondary battery accurately in order to estimate the time period that the device can be operated, and in order to determine the lifetime of the secondary battery and to be certain of the timing at which it should be exchanged for a new secondary battery. In such a device, a system is provided that compares the present charge capacity and the initial charge capacity of the secondary battery, and that notifies the user of the device of the need to exchange the secondary battery when it has been determined that the present charge capacity is less than a predetermined proportion of the initial charge capacity.

In order to ascertain the state of the secondary battery, it is necessary for the system within the device periodically to ascertain the present charge amount (SOC: State Of Charge) of the secondary battery accurately. The SOC is obtained by storing in advance the relationship between the open circuit voltage of the secondary battery (OCV: Open Circuit Voltage) and the SOC as correlation data, by measuring the OCV, and by finding the SOC from the correlation data on the basis of the OCV.

Accordingly it is necessary to measure the OCV accurately in order to obtain an accurate SOC, but, when a large current is flowing in the secondary battery, it is not possible to measure the OCV directly due to the influence of the voltage across the resistance possessed by the secondary battery, and moreover, in a state in which a current is flowing, it is difficult to estimate the OCV at that time point.

For example, as a technique for determining deterioration of a secondary battery, a technique has been proposed in which the change $\Delta SOC$ of the SOC is calculated from changes of open circuit voltages E1 and E2 that are determined in advance, an integrated value $\Delta Ah$ of discharge current while the SOC changes by just $\Delta SOC$ is calculated, and the proportional deterioration of battery capacity is obtained from the integrated discharge current value $\Delta Ah$ and $\Delta SOC$ (refer to Patent Document #1).

CITATION LIST

PATENT LITERATURE

Patent Document #1: Japanese Laid-Open Patent Publication 2002-243813.

SUMMARY OF INVENTION

TECHNICAL PROBLEM

However, in this estimation of the charge capacity of the secondary battery, it is necessary to measure the OCV at the start time point and at the end time point of a predetermined interval; but, if the predetermined interval is measured periodically, if current is flowing at this start time point and at this end time point, it is not possible to measure or to estimate the OCV at those time points, so that it is not possible to estimate the charge capacity of the secondary battery. Moreover, there is a demand for it to be possible to perform estimation of the charge capacity of the secondary battery even while the secondary battery is being used, in other words even while some device is operating.

SOLUTION TO TECHNICAL PROBLEM

According to the 1st aspect of the present invention, a device for assessing an extent of degradation of a secondary battery, comprises: a determination unit that determines whether or not a value of current flowing in the secondary battery is less than a predetermined value; a first voltage measurement unit that takes a time point at which it is determined by the determination unit that the value of the current is less than the predetermined value as being a start time point of a specific interval, and that measures a first battery voltage of the secondary battery at the start time point; a first charge amount calculation unit that obtains a first charge amount corresponding to the secondary battery based upon the measured first battery voltage; a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point; a second charge amount calculation unit that obtains a second charge amount corresponding to the secondary battery based upon the measured second battery voltage; an integrated current amount calculation unit that obtains an integrated amount of the current flowing in the secondary battery during the specific interval; and a charge capacity calculation unit that obtains a difference between the first charge amount and the second charge amount, and that calculates a charge capacity by dividing the integrated amount of the current by the difference.

According to the 2nd aspect of the present invention, in the device for assessing an extent of degradation of a secondary battery according to the 1st aspect, it is preferred that the device further comprises a temperature measurement unit that measures a temperature of the secondary battery, and an extent of degradation of the secondary battery is assessed if the temperature of the secondary battery measured by the temperature measurement unit simultaneously with measurements of battery voltage by the first voltage measurement unit and by the second voltage measurement unit is within a predetermined temperature range.

According to the 3rd aspect of the present invention, in the device for assessing an extent of degradation of a secondary battery according to the 1st or the 2nd aspect, it is preferred that the device further comprises an assessment unit that assesses the extent of degradation of the secondary battery by comparing together the charge capacity that has been calculated and an initial charge capacity of the secondary battery.

According to the 4th aspect of the present invention, in the device for assessing an extent of degradation of a secondary battery according to the 3rd aspect, it is preferred that the assessment unit determines that the secondary battery is degraded, based upon results of assessing the extent of degradation of the secondary battery a predetermined number of times.

According to the 5th aspect of the present invention, in the device for assessing an extent of degradation of a secondary battery according to the 3rd or the 4th aspect, it is preferred that the assessment unit assesses the extent of degradation of the secondary battery if a difference between the first charge amount and the second charge amount is within a predetermined range.

According to the 6th aspect of the present invention, in the device for assessing an extent of degradation of a secondary battery according to any one of the 3rd through the 5th aspects, it is preferred that the assessment unit assesses the extent of degradation of the secondary battery if the integrated amount of the current is within a predetermined range.

According to the 7th aspect of the present invention, a device for assessing an extent of degradation of a secondary battery, comprises: a determination unit that determines whether or not a value of current flowing in the secondary battery is less than a predetermined value; a first voltage measurement unit that takes a time point at which it is determined by the determination unit that the value of the current is less than the predetermined value as being a start time point of a specific interval, and that measures a first battery voltage of the secondary battery at the start time point; a first charge amount calculation unit that obtains a first charge amount corresponding to the secondary battery based upon the measured first battery voltage; a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point; a second charge amount calculation unit that obtains a second charge amount corresponding to the secondary battery based upon the measured second battery voltage; an integrated current amount calculation unit that obtains an integrated amount of the current flowing in the secondary battery during the specific interval; a charge capacity calculation unit that obtains a difference between the first charge amount and the second charge amount; and an output unit that outputs the integrated amount of the current and the difference of the charge amount, wherein the extent of degradation of the secondary battery is assessed based upon the integrated amount of the current and the difference of the charge amount.

ADVANTAGEOUS EFFECTS OF INVENTION

According to the present invention, it is possible to determine the extent of degradation of a secondary battery in an accurate manner by obtaining the charge capacities of the secondary battery over a predetermined interval, even while the secondary battery is being used, in other words even while some device is operating.

BRIEF DESCRIPTION OF DRAWINGS

[Fig. 1] Fig. 1 is a block diagram showing a battery system according to an embodiment of the present invention and its surrounding circuit structure;
[Fig. 2] Fig. 2 is a block diagram showing the circuit structure of a unit cell control unit; [Fig. 3] Fig. 3 is a flow chart showing determination of extent of degradation in a first embodiment of the present invention;
[Fig. 4] Fig. 4 is a flow chart showing determination of extent of degradation in a second embodiment of the present invention;
[Fig. 5] Fig. 5 is a flow chart showing determination of extent of degradation in a third embodiment of the present invention; and
[Fig. 6] Fig. 6 is a flow chart showing determination of extent of degradation in a fourth embodiment of the present invention.

DESCRIPTION OF EMBODIMENTS

In the following embodiments, by way of example, cases in which the present invention is applied to a battery system that constitutes the power supply for a hybrid electric automobile (HEV) or a plug-in hybrid electric automobile (PHEV) will be explained.

Moreover while, by way of example, in the following embodiments, cases are explained in which lithium ion batteries are employed, alternatively, it would also be possible to employ nickel-hydrogen batteries, lead-acid batteries, or the like.

Embodiment #1

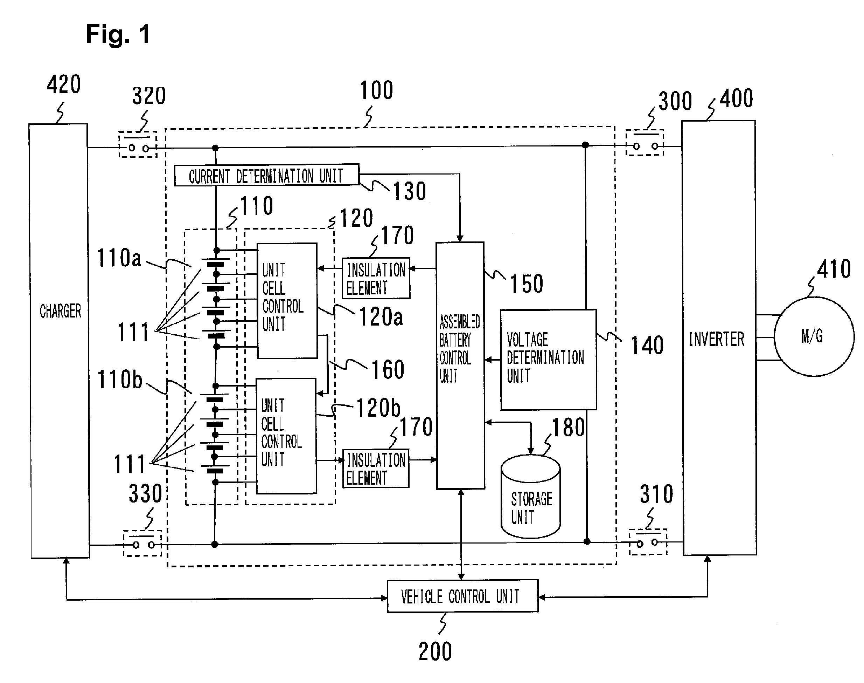

Fig. 1 is a block diagram showing a battery system 100 according to an embodiment of the present invention and its surrounding circuit structure. This battery system 100 is connected to a vehicle control unit 200, and the vehicle control unit 200 controls relays 300 and 310 and thereby connects the battery system 100 to an inverter 400. Moreover, the vehicle control unit 200 controls relays 320 and 330 and thereby connects the battery system 100 to a charger 420.

The battery system comprises an assembled battery 110, a unit cell control section 120, a current determination (detection) unit 130, a voltage determination (detection) unit 140, an assembled battery control unit 150, and a storage unit 180.

The assembled battery 110 is a secondary battery comprising unit cell groups 110a and 110b, with each of the unit cell groups 110a and 110b comprising a plurality of unit cells 111.

This assembled battery 110 is built by electrically connecting in series a plurality of unit cells 111 that are capable of accumulating and delivering electrical energy (i.e. that are capable of charging and discharging DC electrical power). For management and implementation of control of their states of charge and discharge, the unit cells 111 that make up the assembled battery 110 are divided into groups, each group containing a predetermined number of units. The unit cells 111 in each group are electrically connected in series, and are formed into unit cell groups 110a and 110b. It would be acceptable for the unit cell groups 110a and 110b to contain the same number of unit cells 111; or, alternatively, each of the unit cell groups 110a and 110b could contain a different number of unit cells 111. In this embodiment, in the interests of simplicity of explanation, each of the unit cell groups 110a and 110 comprises four unit cells 111 that are electrically connected in series, and the battery groups 110a and 110b are themselves further electrically connected in series, resulting in the assembled battery 110 that comprises a total of eight unit cells 111.

The unit cell control section 120 comprises a unit cell control unit 120a that monitors the state of the unit cells 111 in the unit cell group 110a and a unit cell control unit 120b that monitors the state of the unit cells 111 in the unit cell group 110b.

The current determination unit 130 determines or detects the current flowing in the battery system 100. And the voltage determination unit 140 determines or detects the total voltage of the assembled battery 110.

The assembled battery control unit 150 consists of a microcomputer and so on, and, using information received from the unit cell control section 120, the current determination unit 130, the voltage determination unit 140, the vehicle control unit 200, information stored in the storage unit 180, and so on, executes programs shown in flow charts that will be described hereinafter for determination (assessment) of the extent of degradation (the state of health) of the secondary battery, and, along with determining (assessing) the extent of degradation of the assembled battery 100 which is a secondary battery, also performs calculation of the SOCs of one or more of the unit cells 111, and of the current and electrical power that can be inputted and outputted and so on. And the assembled battery control unit 150 transmits calculation results of various types to the unit cell control section 120 and to the vehicle control unit 200.

The assembled battery control unit 150 receives the cell voltages of the unit cells 111 and temperatures transmitted by the unit cell control section 120, the value of the current flowing in the battery system 100 transmitted by the current determination unit 130, and the total voltage value of the assembled battery 110 transmitted by the voltage determination unit 140. And, on the basis of the information that it has received, the assembled battery control unit 150 determines the state of the assembled battery 110 and controls battery operation.

The assembled battery control unit 150 transmits and receives signals as described below to and from the unit cell control units 120a and 120b that make up the unit cell control section 120. The unit cell control units 120a and 120b are connected in series according to the levels of the electrical potentials of the unit cell groups 110a and 110b that they respectively monitor. Signals that the assembled battery control unit 150 transmits to the unit cell control section 120 via an insulation element 170 are inputted to the unit cell control unit 120a. And the output of the unit cell control unit 120a is inputted via a signal communication means 160 to the unit cell control unit 120b, while the output of the unit cell control unit 120b is transmitted to the assembled battery control unit 150 via another insulation element 170. For example, in response to a request for voltage value from the assembled battery control unit 150 to the unit cell control unit 120a, the unit cell control unit 120a determines the voltage value of the unit cell group 110a and transmits this to the unit cell control unit 120b, and the unit cell control unit 120b determines the voltage value of the unit cell group 110b and transmits this to the assembled battery control unit 150. In this embodiment, no insulation element 170 is interposed between the unit cell control unit 120a and the unit cell control unit 120b, but it would also be possible for them to transmit and receive signals via such an insulation element 170.

The storage unit 180 is installed as connected to the assembled battery control unit 150, and, apart from storing correlation data between OCV and SOCV and the initial charge capacity Q0 of the secondary battery, also stores information about the internal resistance characteristics of the assembled battery 110, of the unit cells 111, and of the unit cell groups 110a and 110b, information about their capacities when fully charged, information about their polarization characteristics, information about their individual differences, and so on. The correlation data between OCV and SOCV is data that is obtained in advance by measurement or the like. SOCV is a value that expresses SOC on a voltage basis; in concrete terms, these are the voltage values measured for SOCs of the secondary battery from 100% to 0% respectively. It should be understood that while, in this embodiment, the storage unit 180 is installed externally to the assembled battery control unit 150, it would also be acceptable to provide a storage unit internally to the assembled battery control unit 150 or internally to the unit cell control section 120, and the information described above could be stored in such a storage unit.

By using information received from the assembled battery control unit 150, the vehicle control unit 200 controls, via the relays 300 and 310, the inverter 400 connected to the battery control system 100. During vehicle propulsion, the battery system 100 is connected to the inverter 100, and a motor-generator 410 is driven by using energy accumulated in the assembled battery 110.

The vehicle control unit 200 controls the charger 420 that is connected to the battery system 100 via the relays 320 and 330. During charging, the battery system 100 is connected to the charger 420, and is charged up by supply of electrical power from a household power supply or from a charging station. The charger 420 is employed when charging up the assembled battery 110 by using an external power supply, of which a household power supply or a charging station is representative. In this embodiment, the charger 420 controls the charging voltage and the charging current and so on based upon commands from the vehicle control unit 200.

When the vehicle system to which this battery system 100 is mounted is started and the vehicle is being propelled, on the basis of management by the vehicle control unit 200, the battery system 100 is connected to the inverter 400 and the motor-generator 410 is driven by using the energy accumulated in the assembled battery 110; while, during regeneration, the assembled battery 110 is charged up by electrical power generated by the motor-generator 410. Since charging and discharging of the assembled battery 110 are performed during propulsion of the vehicle, accordingly time points may be determined at which the absolute value of the current value measured by the current determination unit 130 is less than a predetermined value.

And, when the vehicle to which the battery system 100 is mounted is connected to an external power supply, of which a household power supply or a charging station is representative, the battery system 100 and the charger 420 are connected on the basis of information generated by the vehicle control unit 200, and the assembled battery 110 is charged up until it reaches a predetermined condition. The energy that has been accumulated into the assembled battery 110 due to this charging is utilized for propelling the vehicle the next time that it is traveling, and is also utilized for operating electronic equipment and so on both inside and outside the vehicle.

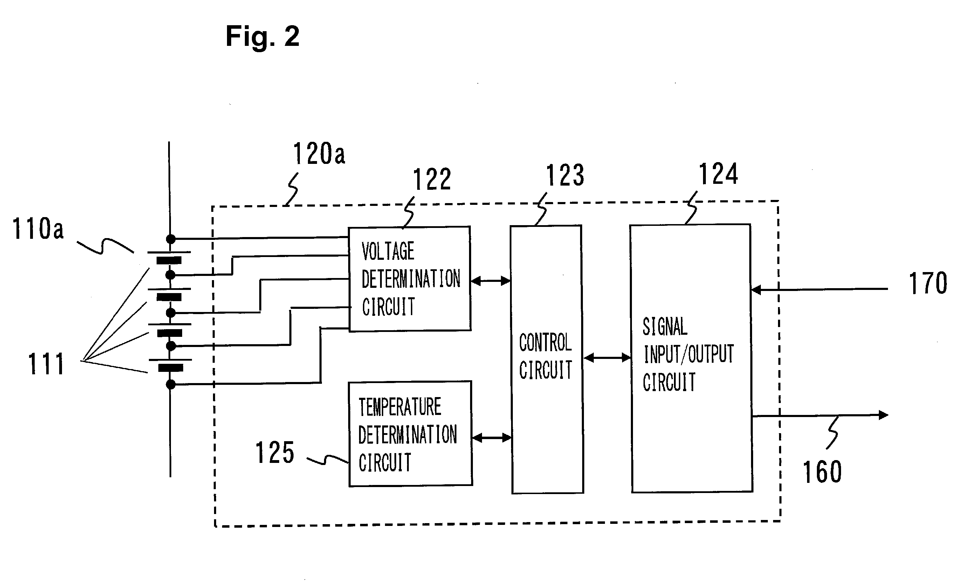

Fig. 2 is a block diagram showing the circuit structure of the unit cell control unit 120a. The unit cell control unit 120b has a similar circuit structure, and accordingly explanation thereof will be omitted. This unit cell control unit 120a comprises a voltage determination circuit 122, a control circuit 123, a signal input/output circuit 124, and a temperature determination unit 125. The voltage determination circuit 122 measures the voltages between the terminals of the unit cells 111, and transmits the total of these voltages to the control circuit 123 as the voltage of the unit cell group 110a. The temperature determination unit 125 measures the temperature of the unit cell group 110a. And the control circuit 123 receives the results of measurement from the voltage determination circuit 122 and the temperature determination unit 123.

In response to a request for voltage value and/or for temperature that has been inputted to the unit cell control unit 120a from the assembled battery control unit 150 via the insulation element 170, the control circuit 123 transmits the voltage value and/or the temperature, which have been determined as previously described, to the unit cell control unit 120b via the signal communication means 160. And, in a similar manner, the unit cell control unit 120b also determines the voltage value and/or the temperature of the unit cell group 110b, and transmits the results to the assembled battery control unit 150 via the insulation element 170. It should be understood that, since a circuit structure is per se known that is frequently implemented in the unit cell control units 120a and 120b and that equalizes fluctuations of the voltages or of the SOCs between the unit cells 111 that are generated together with fluctuations of self-discharge or current consumption or the like, accordingly explanation thereof will here be omitted.

The temperature determination unit 125 that is provided to the unit cell control unit 120a shown in Fig. 2 has the function of measuring the temperature of the unit cell group 110a. A single temperature is measured for the unit cell group 110a, and this is treated as being a representative temperature value for the unit cells 111 that make up the unit cell group 110a, and is used in calculations of various types for determination of the states of the unit cells 111 and the overall state of the unit cell group 110a. Upon this basis, in Fig. 2, a single temperature determination unit 125 is provided to the unit cell control unit 120a. Alternatively, a temperature determination unit 125 could be provided to each of the unit cells 111 for measuring the temperature of that unit cell 111, and calculations of various types could be executed on the basis of the temperatures of each of the unit cells 111; for example, in this embodiment, on the basis of the highest of those temperatures.

It should be understood that, while the temperature determination unit 125 is shown in a simple manner in Fig. 2, actually a temperature sensor is installed at a location in the unit cell group 110a that is to be the subject of temperature measurement, temperature information from this installed temperature sensor is outputted as a voltage, and the control circuit 123 outputs this result that has been measured from the unit cell control unit 120b via the signal input/output circuit 124 to the assembled battery control unit 150. Moreover, instead of the measuring the temperature with the temperature determination unit 125 that is provided to the unit cell control unit 120a, it would also be acceptable to arrange to share the voltage determination circuit 122 for measuring the temperature.

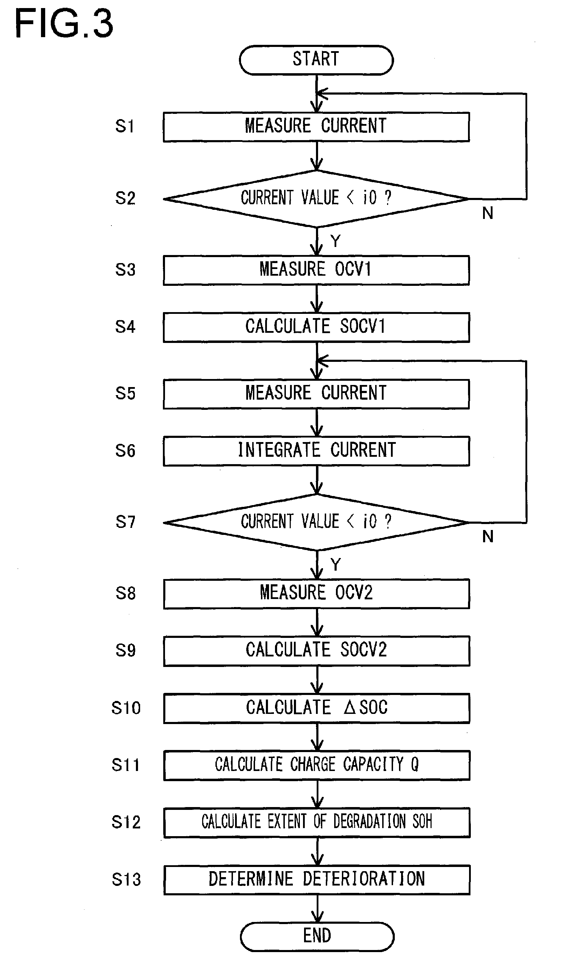

Next, the operation according to this first embodiment of the present invention for determining (assessing) the extent of degradation of a secondary battery will be explained with reference to Fig. 3.

Fig. 3 is a flow chart for this determination (assessment) of the extent of degradation of a secondary battery. During propulsion of the vehicle, the processing operations shown in this flow chart are repeatedly executed by the assembled battery control unit 150 continuously or upon a predetermined cycle.

In step S1, the assembled battery control unit 150 acquires the current value I determined by the current determination unit 130 five times in succession, for example at intervals of 100 msec. And then in step S2 the assembled battery control unit 150 calculates the average value IAVE of the absolute values of these five successive current values I, and determines whether or not the result is less than a predetermined value i0 A (i0 amperes), that may for example be 5 A. If the average current value IAVE is greater than or equal to 5 A, then the current measurement of step S1 and the decision of step S2 are repeated until the average current value IAVE becomes less than 5 A. It should be understood that, during vehicle propulsion, the motor-generator 410 is powered by using energy from the assembled battery 110, which is a secondary battery; while, during vehicle braking, in other words during deceleration or while the vehicle is descending a slope or the like, the motor-generator 410 is operated in the power generation mode upon rotatory power from the vehicle wheels transmitted via the drive system, so that the assembled battery 110 is charged by regenerated energy. Charging and discharging of this assembled battery 110 are performed repeatedly, and, at the time point when the system transitions from discharging to charging, or from charging to discharging, there is a timing at which the current value I almost becomes 0 A; in this embodiment, when it has been determined that the average value of the absolute values of five current values in succession has been less than 5A, then it is determined that this is the timing at which the current value I became almost 0 A. This example in which the current value I is acquired five times in succession at intervals of 100 msec is not intended to be limitative; it would also be acceptable to arrange for the current value I that flows during a short time interval to be acquired.

When the average current value IAVE is less than the predetermined value i0 A, which for example is 5 A, then in step S3 the voltage of the secondary battery measured by the voltage determination circuit 122 within the unit cell control section 120 is acquired as OCV1 (the "first battery voltage"). Since correlation data between OCV and SOCV is stored in the storage unit 180 that is connected to the assembled battery control unit 150, accordingly in step S4 a SOCV (the "first charge amount") is found from OCV1 by using the correlation data between OCV and SOCV stored in the storage unit 180, and this SOCV is recorded in the assembled battery control unit 150.

Then in step S5, in a similar manner to the case in step S1 above, the assembled battery control unit 150 acquires the current value I determined by the current determination unit 130 five times in succession, for example at intervals of 100 msec. And then in step S6, according to Equation (1) below, the assembled battery control unit 150 calculates the integrated current amount of this current value I, integrated over the interval from the timing at which it was determined in step S2 described above that the average value IAVE of the absolute value of the current value I was less than the predetermined value i0 A, until the timing of a further determination in step S7 that will be described hereinafter that the average value IAVE of the absolute value of the current value I was less than the predetermined value i0 A.

$$\text{Integrated current amount} = \int I \, dt \; ... \; (1)$$

Next in step S7, in a similar manner to the case in step S2 described above, the assembled battery control unit 150 calculates the average value IAVE of the absolute values of five successive current values I, and determines whether or not the result is less than the predetermined value i0 A (i0 amperes), which for example is 5 A. If the average current value IAVE is greater than or equal to 5 A, then the current measurement of step S5, the ongoing integration of the current amount in step S6, and the decision of step S7 are repeated until the average current value IAVE becomes less than 5 A.

In step S7, if the average value of the absolute values of the average current value IAVE is less than the predetermined value i0 A, for example 5 A, then the integration of the current is stopped, and the integrated current amount over this interval is checked and is recorded by the assembled battery control unit 150.

Then in step S8 the voltage of the secondary battery that was measured by the voltage determination circuit 122 in the unit cell control section 120 is acquired as OCV2 (the "second battery voltage"). And, since correlation data between OCV and SOCV is stored in the storage unit 180 that is connected to the assembled battery control unit 150, accordingly in step S9 a value SOCV2 (the "second charge amount") is found from OCV2 by using the stored correlation data between OCV and SOCV, and this is recorded in the assembled battery control unit 150. At this time, in order to calculate the SOCV more accurately, not only is the correlation data between OCV and SOCV that is stored in the storage unit 180 used, but also SOCV may be obtained and recorded in the control unit 150 by employing some type of specified SOC calculation logic.

The start time point of the interval over which the integrated current amount will be obtained is determined by the processing of steps S1 and S2 described above, and in steps S3 and S4 the value SOCV1 at this start time point is obtained. Then the end time point of this interval over which the integrated current amount has been obtained is determined by the processing of steps S5 and S7 described above, and in steps S8 and S9 the value SOCV2 at this end time point is obtained. And in step S6 the integral of the current amount from the start time point to the end time point is obtained.

Due to the processing of steps S1 and S2 described above and the processing of steps S5 and S7 described above, the start time point and the end time point are each taken as being a time point when, over a short time interval (for example 100 msec X 5), the absolute values of the current values measured are less than the predetermined value i0 A. By doing this, even if the current is flowing intermittently while a device is being used, by measuring secondary battery voltages that are captured in the state in which the current that is flowing is less than the predetermined value i0 A, in other words in a state in which a not very great current is flowing, it becomes possible to measure secondary battery voltages that are closer to the OCVs, so that it is possible to obtain the SOCs at the start time point and at the end time point of obtaining the integrated current amount more accurately; and, due to this, it is possible to obtain an accurate charge capacity, so that it becomes possible to perform accurate determination of the extent of degradation of the secondary battery, as will be described hereinafter.

Next, in step S10, the difference ΔSOC is obtained between the values of SOCV1 and of SOCV2 that have been recorded by the assembled battery control unit 150. And then in step S11 the charge capacity Q is obtained according to the following Equation (2), using the integrated current amount that has been recorded by the assembled battery control unit 150 and ΔSOC:

$$Q = \int I\, dt\, /\, \Delta SOC \;...\; (2)$$

Next in step S12 the extent of degradation (the state of health) SOH is calculated according to the following Equation (3) from the charge capacity Q that has been calculated as described above and the initial charge amount Q0 of the secondary battery, which is stored in the storage unit 180:

$$SOH = Q\, /\, Q0 \;...\; (3)$$

And, in step S 13, if the calculated extent of degradation SOH is below a fixed value, then it may be decided that the secondary battery has deteriorated. If it has been decided that the secondary battery has deteriorated, then this deterioration of the secondary battery is notified to the user via display of a message to that effect, or via a warning lamp, an alarm sound, an audio message or the like that indicates deterioration.

Moreover, by repeatedly executing the processing operations for determination of the extent of degradation of the secondary battery shown in Fig. 3, the number of times that it has been determined in step S13 which is repeatedly executed that the calculated extent of degradation SOH has dropped below the fixed value may be counted, and, if a predetermined number of times has been counted, then a notification that it has been determined that the secondary battery has deteriorated may be issued; and in that case it is possible to notify this result that determination of the extent of degradation of the secondary battery has been performed to the user in a more reliable manner. It should be understood that it would also be acceptable to issue a notification of deterioration if dropping of the extent of degradation SOH below the fixed value has continued for a predetermined number of times successively.

The determination of the extent of degradation is not limited to the use of Equation (3) described above; it could also be performed according to an equation that compares the charge capacity Q with the initial charge amount Q0 of the secondary battery.

According to the first embodiment as described above, it is possible to measure secondary battery voltages that are close to the OCVs even while the vehicle is traveling, by considering portions of the operation in which not a great deal of current is flowing. And, since it is possible to obtain more accurate SOCVs from these OCVs and to obtain a more accurate charge capacity Q by using these SOCVs, accordingly it is possible to determine the extent of degradation of the secondary battery more correctly.

As described above, the operational flow for determination of the extent of degradation of a secondary battery shown in Fig. 3 is executed repeatedly while the vehicle is being propelled, but accurate determinations at those time points could also be performed individually.

Embodiment #2

Next, a second embodiment of the present invention will be explained. Since a block diagram showing the circuit structure of the battery system 100 according to this second embodiment and of its surrounding circuitry would be the same as Fig. 1 and a block diagram showing the circuit structure of the unit cell control unit 120a would be the same as Fig. 2, accordingly such block diagrams and explanation thereof are omitted.

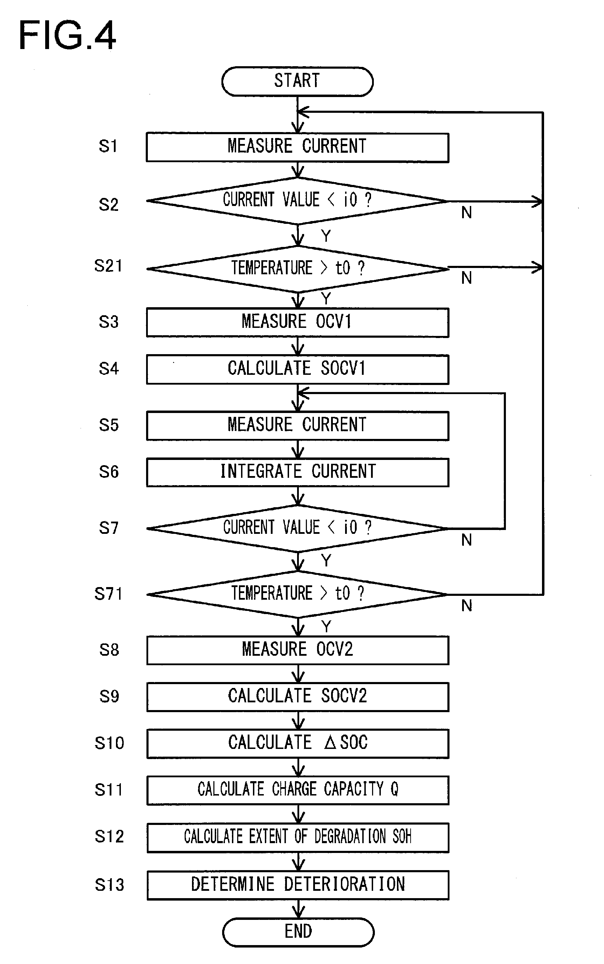

Next, the operation according to this second embodiment of the present invention for determining the extent of degradation of a secondary battery will be explained with reference to Fig. 4.

Fig. 4 is a flow chart for this determination of the extent of degradation of a secondary battery. During propulsion of the vehicle, the processing operations shown in this flow chart are repeatedly executed by the assembled battery control unit 150 continuously or upon a predetermined cycle; and moreover, to steps that perform the same processing operations as steps shown in Fig. 3 described above, the same reference symbols will be appended, and explanation thereof will be omitted.

In Fig. 4, in step S2, the average value IAVE of the absolute values of five consecutive current values is calculated and it is determined whether or not this value IAVE is less than a predetermined value i0 A, for example 5 A, and, if it is determined that this average value of the absolute values of five consecutive current values is less than 5 A, then the flow of control is transferred to step S21. In this step S21, a decision is made as to whether or not the secondary battery temperatures T as determined by the temperature determination units 125 in the unit cell control units 120a and 120b are in the range higher than a predetermined temperature t0, for example 10°C. While one temperature determination unit 125 is provided to each of the unit cell control units 120a and 120b, this determination is made according to the temperature that is the lower, among the two temperatures transmitted to the assembled battery control unit 150 from each of the unit cell control units 120a and 120b. If in step S21 it is determined that the secondary battery temperatures T are in the range higher than the predetermined value t0, for example 10°C, then the processing of step S3 is performed, while if it is determined that one or more of the secondary battery temperatures T are less than or equal to 10°C then the flow of control returns to step S 1.

In step S7, the average value IAVE of the absolute values of five consecutive current values is calculated, and it is determined whether or not this value IAVE is less than the predetermined value i0 A, for example 5 A, and, if it is determined that this average value of the absolute values of five consecutive current values is less than 5 A, then the flow of control is transferred to step S71. And in this step S71 a decision is made as to whether or not both of the secondary battery temperatures T as determined by the temperature determination units 125 in the unit cell control units 120a and 120b are in the range higher than the predetermined temperature t0, for example 10°C. If in step S71 it is determined that the secondary battery temperatures T are in the range higher than the predetermined value t0, for example 10°C, then the processing of step S8 is performed, while if it is determined that one or more of the secondary battery temperatures T are less than or equal to 10°C then the flow of control returns to step S1.

Thus, in this second embodiment, the measurement of OCV1 in step S3 and the measurement of OCV2 in step S8 are not performed if the secondary battery temperature T as determined by the temperature determination unit 125 within the unit cell control section 120 is less than or equal to, for example, 10°C.

Since the internal resistance of the secondary battery becomes higher than normal when the secondary battery is in a low temperature state, accordingly at low temperature, even in the state in which only a small current is flowing, in some cases the secondary battery voltage may deviate substantially from the OCV, due to the large internal resistance. In this case, since the SOCV that is found from the OCV will be inaccurate, accordingly there is a danger that the charge capacity will not be determined accurately. Therefore at low temperature, in the manner described above, by executing steps S21 and S71, decisions are made as to whether or not the temperature T as measured by the temperature determination unit 125 within the unit cell control section 120 is in the range higher than the predetermined value t0, for example 10°C, whereby it is ensured that obtaining inaccurate SOCV and obtaining a consequent inaccurate charge capacity Q will be avoided, and accordingly that no erroneous determination of deterioration will be reached.

By repeatedly executing the operations shown in this flow chart for determination of the extent of degradation of a secondary battery, it is possible to determine the charge capacity in a more accurate manner, and it is possible to perform determination of the correct extent of degradation.

Embodiment #3

Next, a third embodiment of the present invention will be explained. Since a block diagram showing the circuit structure of the battery system 100 according to this third embodiment and its surrounding circuitry would be the same as Fig. 1 and a block diagram showing the circuit structure of the unit cell control unit 120a would be the same as Fig. 2, accordingly such block diagrams and explanation thereof are omitted.

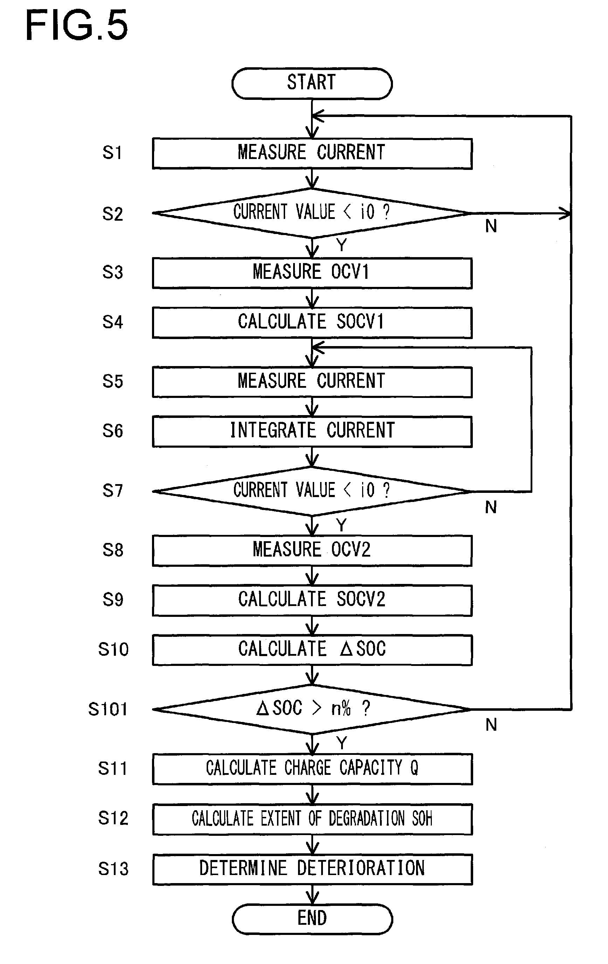

Now, the operation according to this third embodiment of the present invention for determining the extent of degradation of a secondary battery will be explained with reference to Fig. 5.

Fig. 5 is a flow chart for this determination of the extent of degradation of a secondary battery. During propulsion of the vehicle, the processing operations shown in this flow chart are repeatedly executed by the assembled battery control unit 150 continuously or upon a predetermined cycle; and moreover, to steps that perform the same processing operations as steps shown in Fig. 3 described above, the same reference symbols will be appended, and explanation thereof will be omitted.

In Fig. 5, in step S10, after having obtained the difference ΔSOC between SOCV1 and SOCV2 as recorded by the assembled battery control unit 150, the processing of step S101 is performed. In this step S101, if ΔSOC is in the range greater than a predetermined value n%, for example 2%, then the processing of step S11 is performed, whereas if ΔSOC is less than or equal to 2%, then the flow of control returns to the processing of step S1.

If ΔSOC, which is the difference between the charge amounts, is small, then there is a possibility that the error proportion in the calculation of SOC, which is included in ΔSOC, may become large. In this case, there is a danger that the charge capacity will not be obtained accurately. In order to avoid this, in step S101 described above, it is checked that ΔSOC is in the range greater than the predetermined value n%, for example 2%, and if ΔSOC is less than the predetermined value n%, then calculation of the charge capacity is not performed.

It should be understood that it would be possible to combine the second embodiment described above and this third embodiment. In other words it would be acceptable to arrange to provide a processing flow in which the measurement of OCV1 in step S3 and the measurement of OCV2 in step S8 are not performed if the temperature T of a secondary battery as determined by a temperature determination unit 125 in the unit cell control section 120 is less than or equal to the predetermined value t0, and moreover in which the calculation of charge capacity in step S11 is not performed if ΔSOC is less than the predetermined value n%.

By repeatedly executing the operations shown in this flow chart for determination of the extent of degradation of a secondary battery, it is possible to determine the charge capacity in a more accurate manner, and it is possible to perform determination of the correct extent of degradation.

Embodiment #4

Next, a fourth embodiment of the present invention will be explained. Since a block diagram showing the circuit structure of the battery system 100 according to this fourth embodiment and of its surrounding circuitry would be the same as Fig. 1 and a block diagram showing the circuit structure of the unit cell control unit 120a would be the same as Fig. 2, accordingly such block diagrams and explanation thereof are omitted.

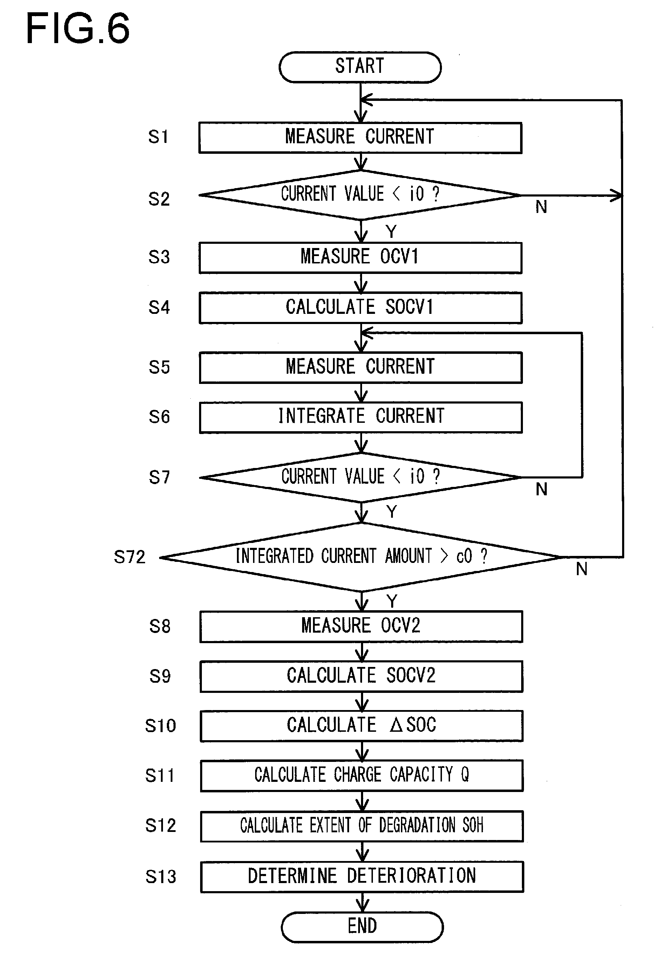

Next, the operation according to this fourth embodiment of the present invention for determining the extent of degradation of a secondary battery will be explained with reference to Fig. 6.

Fig. 6 is a flow chart for this determination of the extent of degradation of a secondary battery. During propulsion of the vehicle, the processing operations shown in this flow chart are repeatedly executed by the assembled battery control unit 150 continuously or upon a predetermined cycle; and moreover, to steps that perform the same processing operations as steps shown in Fig. 3 described above, the same reference symbols will be appended, and explanation thereof will be omitted.

In Fig. 6, in step S7, if the average value of the absolute values of the average current value IAVE is less than the predetermined value i0 A, for example 5 A, then current integration is stopped, the integrated current amount during this interval is checked, and, after recording this in the assembled battery control unit 150, the processing of step S72 is executed. In this step S72 it is determined whether or not the integrated current amount is greater than a predetermined value c0, for example 500 As, and if it is not greater then the flow of control returns to the processing of step S1, while if it is greater then the processing of step S8 is executed.

If the integrated current amount is small, then there is a possibility that the influence of current measurement errors upon the integrated current amount may become large. In this case, since the integrated current amount becomes inaccurate, accordingly there is a danger that the charge capacity may not be obtained accurately. Therefore the processing of steps S8 and subsequent steps is executed only after it has been checked in the processing of step S72 that the integrated current amount is greater than the predetermined value c0, for example 500 As, and accordingly obtaining an inaccurate charge capacity Q is avoided, whereby it is ensured that no erroneous determination of deterioration will be reached.

It should be understood that it would be possible to combine this fourth embodiment with the second embodiment and the third embodiment described above. In other words it would be acceptable to arrange to provide a processing flow that does not perform the measurement of OCV1 in step S3 and the measurement of OCV2 in step S8 if the temperature T of a secondary battery as determined by a temperature determination unit 125 in the unit cell control section 120 is less than or equal to the predetermined value t0, and that does not perform the calculation of charge capacity in step S11 if ΔSOC is less than the predetermined value n%, and moreover that does not perform determination of the extent of degradation if the integrated current amount is not greater than the predetermined value c0.

Yet further, it would also be possible to combine this fourth embodiment with the second embodiment or the third embodiment described above. In other words it would be acceptable to arrange to provide a processing flow that does not perform the measurement of OCV1 in step S3 and the measurement of OCV2 in step S8 if the temperature T of a secondary battery as determined by a temperature determination unit 125 in the unit cell control section 120 is less than or equal to the predetermined value t0, or that does not perform the calculation of charge capacity in step S11 if ΔSOC is less than the predetermined value n%, and in either case that does not perform determination of the extent of degradation if the integrated current amount is not greater than the predetermined value c0.

By repeatedly executing the operations shown in this flow chart for determination of the extent of degradation of a secondary battery, it is possible to determine the charge capacity in a more accurate manner, and to perform determination of the correct extent of degradation.

Variant embodiments

In the embodiments described above, examples were shown in which the processing flow for determination of the extent of degradation of a secondary battery shown in Fig. 3, Fig. 4, Fig. 5, and Fig. 6 were all executed by the assembled battery control unit 150. However, it would also be acceptable for all or a portion of the steps of the processing flow for determination of the extent of degradation of a secondary battery to be performed by the vehicle control unit 200 or by the unit cell control section 120. For example, it would also be possible, in the processing for determination of the extent of degradation of a secondary battery of step S 13, for the decision to be performed by the vehicle control unit 200 that has received, from the battery control unit 150, the charge capacity Q that has been calculated and the initial charge amount Q0 of the secondary battery that is stored in the storage unit 180.

Furthermore, in the embodiments described above, examples were shown in which the processing flow for determination of the extent of degradation of a secondary battery shown in Fig. 3, Fig. 4, Fig. 5, and Fig. 6 were all executed by the assembled battery control unit 150. However, it would also be acceptable for all or a portion of the steps of the processing flow for determination of the extent of degradation of a secondary battery to be performed by the vehicle control unit 200 or by the unit cell control section 120, and for the data required for determining the extent of degradation of the secondary battery to be outputted. For example, it would be possible to arrange for the assembled battery control unit 150 to comprise a charge capacity calculation unit that obtains the difference between the first charge amount and the second charge amount, and an output unit that outputs this difference between the first charge amount and the second charge amount, and for the vehicle control unit 200 to determine the extent of degradation of the secondary battery by obtaining the charge capacity on the basis of the integrated current amount and the difference of charge amount, and to compare this charge capacity with the initial charge amount Q0.

The present invention is not to be considered as being limited by the embodiments described above; provided that the essential characteristics of the present invention are preserved, other embodiments that may be considered to fall within the range of the technical concept of the present invention are also included within its scope.

Claims

1. A device for assessing an extent of degradation of a secondary battery, comprising:

a determination unit that determines whether or not a value of current flowing in the secondary battery is less than a predetermined value;
a first voltage measurement unit that takes a time point at which it is determined by the determination unit that the value of the current is less than the predetermined value as being a start time point of a specific interval, and that measures a first battery voltage of the secondary battery at the start time point;
a first charge amount calculation unit that obtains a first charge amount corresponding to the secondary battery based upon the measured first battery voltage;
a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point;
a second charge amount calculation unit that obtains a second charge amount corresponding to the secondary battery based upon the measured second battery voltage;
an integrated current amount calculation unit that obtains an integrated amount of the current flowing in the secondary battery during the specific interval; and
a charge capacity calculation unit that obtains a difference between the first charge amount and the second charge amount, and that calculates a charge capacity by dividing the integrated amount of the current by the difference.

2. The device for assessing an extent of degradation of a secondary battery according to Claim 1, further comprising:

a temperature measurement unit that measures a temperature of the secondary battery, wherein an extent of degradation of the secondary battery is assessed if the temperature of the secondary battery measured by the temperature measurement unit simultaneously with measurements of battery voltage by the first voltage measurement unit and by the second voltage measurement unit is within a predetermined temperature range.

3. The device for assessing an extent of degradation of a secondary battery according to Claim 1 or Claim 2, further comprising:

an assessment unit that assesses the extent of degradation of the secondary battery by comparing together the charge capacity that has been calculated and an initial charge capacity of the secondary battery.

4. The device for assessing an extent of degradation of a secondary battery according to Claim 3, wherein the assessment unit determines that the secondary battery is degraded, based upon results of assessing the extent of degradation of the secondary battery a predetermined number of times.

5. The device for assessing an extent of degradation of a secondary battery according to Claim 3 or Claim 4, wherein the assessment unit assesses the extent of degradation of the secondary battery if a difference between the first charge amount and the second charge amount is within a predetermined range.

6. The device for assessing an extent of degradation of a secondary battery according to any one of Claims 3 through 5, wherein the assessment unit assesses the extent of degradation of the secondary battery if the integrated amount of the current is within a predetermined range.

7. A device for assessing an extent of degradation of a secondary battery, comprising:

a determination unit that determines whether or not a value of current flowing in the secondary battery is less than a predetermined value; a first voltage measurement unit that takes a time point at which it is determined by the determination unit that the value of the current is less than the predetermined value as being a start time point of a specific interval, and that measures a first battery voltage of the secondary battery at the start time point; a first charge amount calculation unit that obtains a first charge amount corresponding to the secondary battery based upon the measured first battery voltage; a second voltage measurement unit that, after the first battery voltage has been measured by the first voltage measurement unit, takes a time point at which it is determined by the determination unit that the value of the current is less than the predetermined value as being an end time point of the specific interval, and that measures a second battery voltage of the secondary battery at the end time point;

a second charge amount calculation unit that obtains a second charge amount corresponding to the secondary battery based upon the measured second battery voltage; an integrated current amount calculation unit that obtains an integrated amount of the current flowing in the secondary battery during the specific interval; a charge capacity calculation unit that obtains a difference between the first charge amount and the second charge amount; and an output unit that outputs the integrated amount of the current and the difference of the charge amount, wherein the extent of degradation of the secondary battery is assessed based upon the integrated amount of the current and the difference of the charge amount.

**Fig. 1**

EP 2 963 432 A1

**Fig. 2**

VOLTAGE DETERMINATION CIRCUIT

TEMPERATURE DETERMINATION CIRCUIT

CONTROL CIRCUIT

SIGNAL INPUT/OUTPUT CIRCUIT

110a

111

120a

122

123

124

125

170

160

EP 2 963 432 A1

# FIG.3

```
                    ┌─────────────────┐
                    │      START      │
                    └────────┬────────┘
                             │ ◄─────────────────┐
        S1      ┌────────────▼────────────┐      │
                │     MEASURE  CURRENT     │      │
                └────────────┬────────────┘      │
                             │                    │
        S2         ◄─── CURRENT VALUE < i0 ? ───┐ │
                             │ N ───────────────┘
                             │ Y
        S3      ┌────────────▼────────────┐
                │      MEASURE  OCV1       │
                └────────────┬────────────┘
        S4      ┌────────────▼────────────┐
                │     CALCULATE  SOCV1     │
                └────────────┬────────────┘
                             │ ◄─────────────────┐
        S5      ┌────────────▼────────────┐      │
                │     MEASURE  CURRENT     │      │
                └────────────┬────────────┘      │
        S6      ┌────────────▼────────────┐      │
                │     INTEGRATE  CURRENT   │      │
                └────────────┬────────────┘      │
                             │                    │
        S7         ◄─── CURRENT VALUE < i0 ? ───┐ │
                             │ N ───────────────┘
                             │ Y
        S8      ┌────────────▼────────────┐
                │      MEASURE  OCV2       │
                └────────────┬────────────┘
        S9      ┌────────────▼────────────┐
                │     CALCULATE  SOCV2     │
                └────────────┬────────────┘
        S10     ┌────────────▼────────────┐
                │    CALCULATE  ΔSOC       │
                └────────────┬────────────┘
        S11     ┌────────────▼────────────┐
                │ CALCULATE CHARGE CAPACITY Q │
                └────────────┬────────────┘
        S12     ┌────────────▼────────────┐
                │ CALCULATE EXTENT OF DEGRADATION SOH │
                └────────────┬────────────┘
        S13     ┌────────────▼────────────┐
                │  DETERMINE DETERIORATION │
                └────────────┬────────────┘
                    ┌────────▼────────┐
                    │       END       │
                    └─────────────────┘
```

# FIG.4

```
                    ┌──────────────┐
                    │    START     │
                    └──────────────┘
                           │
                           ▼
S1          ┌─────────────────────────────┐
            │       MEASURE CURRENT        │
            └─────────────────────────────┘
                           │
                           ▼
S2          < CURRENT VALUE < i0 ? >────── N ──►
                           │ Y
                           ▼
S21         < TEMPERATURE > t0 ? >────── N ──►
                           │ Y
                           ▼
S3          ┌─────────────────────────────┐
            │        MEASURE OCV1          │
            └─────────────────────────────┘
                           │
                           ▼
S4          ┌─────────────────────────────┐
            │       CALCULATE SOCV1        │
            └─────────────────────────────┘
                           │
                           ▼
S5          ┌─────────────────────────────┐
            │       MEASURE CURRENT        │
            └─────────────────────────────┘
                           │
                           ▼
S6          ┌─────────────────────────────┐
            │      INTEGRATE CURRENT       │
            └─────────────────────────────┘
                           │
                           ▼
S7          < CURRENT VALUE < i0 ? >────── N ──►
                           │ Y
                           ▼
S71         < TEMPERATURE > t0 ? >────── N ──►
                           │ Y
                           ▼
S8          ┌─────────────────────────────┐
            │        MEASURE OCV2          │
            └─────────────────────────────┘
                           │
                           ▼
S9          ┌─────────────────────────────┐
            │       CALCULATE SOCV2        │
            └─────────────────────────────┘
                           │
                           ▼
S10         ┌─────────────────────────────┐
            │        CALCULATE ΔSOC        │
            └─────────────────────────────┘
                           │
                           ▼
S11         ┌─────────────────────────────┐
            │  CALCULATE CHARGE CAPACITY Q │
            └─────────────────────────────┘
                           │
                           ▼
S12         ┌─────────────────────────────┐
            │ CALCULATE EXTENT OF DEGRADATION SOH │
            └─────────────────────────────┘
                           │
                           ▼
S13         ┌─────────────────────────────┐
            │    DETERMINE DETERIORATION   │
            └─────────────────────────────┘
                           │
                           ▼
                    ┌──────────────┐
                    │     END      │
                    └──────────────┘
```

# FIG.5

```
                    ┌─────────────┐
                    │    START    │
                    └─────────────┘
                           │
                           ▼  ◄──────────────────────────┐
S1      ┌──────────────────────────────────┐             │
        │         MEASURE  CURRENT          │             │
        └──────────────────────────────────┘             │
                           │                              │
                           ▼                              │
S2         ◄────────────────────────────────►  N         │
              CURRENT VALUE < i0 ?            ─────────────┤
                           │ Y                            │
                           ▼                              │
S3      ┌──────────────────────────────────┐             │
        │          MEASURE  OCV1            │             │
        └──────────────────────────────────┘             │
                           │                              │
                           ▼                              │
S4      ┌──────────────────────────────────┐             │
        │         CALCULATE  SOCV1          │             │
        └──────────────────────────────────┘             │
                           │                              │
                           ▼  ◄──────────────────────┐    │
S5      ┌──────────────────────────────────┐         │    │
        │         MEASURE  CURRENT          │         │    │
        └──────────────────────────────────┘         │    │
                           │                          │    │
                           ▼                          │    │
S6      ┌──────────────────────────────────┐         │    │
        │        INTEGRATE  CURRENT         │         │    │
        └──────────────────────────────────┘         │    │
                           │                          │    │
                           ▼                          │    │
S7         ◄────────────────────────────────►  N     │    │
              CURRENT VALUE < i0 ?            ─────────┘    │
                           │ Y                            │
                           ▼                              │
S8      ┌──────────────────────────────────┐             │
        │          MEASURE  OCV2            │             │
        └──────────────────────────────────┘             │
                           │                              │
                           ▼                              │
S9      ┌──────────────────────────────────┐             │
        │         CALCULATE  SOCV2          │             │
        └──────────────────────────────────┘             │
                           │                              │
                           ▼                              │
S10     ┌──────────────────────────────────┐             │
        │         CALCULATE  △SOC           │             │
        └──────────────────────────────────┘             │
                           │                              │
                           ▼                              │
S101       ◄────────────────────────────────►  N         │
                 △SOC > n% ?                 ─────────────┘
                           │ Y
                           ▼
S11     ┌──────────────────────────────────┐
        │    CALCULATE CHARGE CAPACITY Q    │
        └──────────────────────────────────┘
                           │
                           ▼
S12     ┌──────────────────────────────────┐
        │ CALCULATE EXTENT OF DEGRADATION SOH│
        └──────────────────────────────────┘
                           │
                           ▼
S13     ┌──────────────────────────────────┐
        │      DETERMINE DETERIORATION      │
        └──────────────────────────────────┘
                           │
                           ▼
                    ┌─────────────┐
                    │     END     │
                    └─────────────┘
```

# FIG.6

```
                    ┌─────────────┐
                    │    START    │
                    └──────┬──────┘
                           │ ◄──────────────────────────┐
      S1    ┌──────────────▼──────────────┐             │
            │      MEASURE CURRENT         │             │
            └──────────────┬──────────────┘             │
                           │                             │
      S2         ◄──────────────────►                    │
              CURRENT VALUE < i0 ?        N ─────────────┤
                    Y │                                  │
      S3    ┌─────────▼───────────────────┐             │
            │       MEASURE OCV1           │             │
            └─────────┬───────────────────┘             │
      S4    ┌─────────▼───────────────────┐             │
            │      CALCULATE SOCV1         │             │
            └─────────┬───────────────────┘             │
                      │ ◄──────────────────┐            │
      S5    ┌─────────▼───────────────────┐│            │
            │      MEASURE CURRENT         ││            │
            └─────────┬───────────────────┘│            │
      S6    ┌─────────▼───────────────────┐│            │
            │     INTEGRATE CURRENT        ││            │
            └─────────┬───────────────────┘│            │
                      │                     │            │
      S7         ◄──────────────►           │            │
             CURRENT VALUE < i0 ?    N ──────┘            │
                 Y │                                     │
      S72     ◄──────────────────────►                   │
         INTEGRATED CURRENT AMOUNT > c0 ?   N ───────────┘
                Y │
      S8    ┌──────▼──────────────────┐
            │     MEASURE OCV2         │
            └──────┬──────────────────┘
      S9    ┌──────▼──────────────────┐
            │    CALCULATE SOCV2       │
            └──────┬──────────────────┘
      S10   ┌──────▼──────────────────┐
            │    CALCULATE △SOC        │
            └──────┬──────────────────┘
      S11   ┌──────▼──────────────────┐
            │ CALCULATE CHARGE CAPACITY Q │
            └──────┬──────────────────┘
      S12   ┌──────▼──────────────────┐
            │ CALCULATE EXTENT OF DEGRADATION SOH │
            └──────┬──────────────────┘
      S13   ┌──────▼──────────────────┐
            │  DETERMINE DETERIORATION │
            └──────┬──────────────────┘
                   │
            ┌──────▼──────┐
            │     END     │
            └─────────────┘
```

**INTERNATIONAL SEARCH REPORT**

| International application No. |
| --- |
| PCT/JP2013/055481 |

A. CLASSIFICATION OF SUBJECT MATTER
*G01R31/36*(2006.01)i

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched
Jitsuyo Shinan Koho          1922–1996     Jitsuyo Shinan Toroku Koho     1996–2013
Kokai Jitsuyo Shinan Koho    1971–2013     Toroku Jitsuyo Shinan Koho     1994–2013

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2008-241358 A  (Sanyo Electric Co., Ltd.),<br>09 October 2008 (09.10.2008),<br>claim 1; paragraphs [0021] to [0038]; fig. 1, 4<br>& US 2008/0238371 A1    & EP 1975636 A2 | 1-7 |
| Y | JP 8-29505 A  (Toshiba Corp.),<br>02 February 1996 (02.02.1996),<br>abstract; claim 1; paragraphs [0012], [0023],<br>[0024]<br>(Family: none) | 1-7 |
| Y | JP 2012-83317 A  (Toyota Motor Corp.),<br>26 April 2012 (26.04.2012),<br>claims 6, 14; paragraph [0052]<br>(Family: none) | 2 |

☒  Further documents are listed in the continuation of Box C.          ☐  See patent family annex.

| | |
| --- | --- |
| *     Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>      16 April, 2013 (16.04.13) | Date of mailing of the international search report<br>      23 April, 2013 (23.04.13) |
| --- | --- |
| Name and mailing address of the ISA/<br>   Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2013/055481

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2003-214248 A  (Denso Corp.),<br>30 July 2003 (30.07.2003),<br>claim 7; paragraphs [0016] to [0018]<br>(Family: none) | 4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002243813 A